Europäisches Patentamt

European Patent Office

Office européen des brevets

(11) Veröffentlichungsnummer: **0 348 539**
**A1**

(12) **EUROPÄISCHE PATENTANMELDUNG**

(21) Anmeldenummer: 88110267.7

(22) Anmeldetag: 28.06.88

(51) Int. Cl.⁴: **H03K 19/177 , H03K 5/14**

(43) Veröffentlichungstag der Anmeldung:
03.01.90 Patentblatt 90/01

(84) Benannte Vertragsstaaten:
DE FR NL

(71) Anmelder: **Deutsche ITT Industries GmbH**
**Hans-Bunte-Strasse 19 Postfach 840**
**D-7800 Freiburg(DE)**

(72) Erfinder: **Caesar, Knut Dipl.-Ing.**
**Ettenheimer Str. 16**
**D-7800 Freiburg i. Br.(DE)**
Erfinder: **Häringer, Helmut Dipl.-Ing**
**Oberdorfstr. 14**
**D-7809 Niederwinden(DE)**

(54) **Programmierbares CMOS-Logik-Feld.**

(57) Dieses ist nichtüberlappend zweiphasen-getaktet und enthält in der Dummy-Zeile (zd) seines UND-Bereichs (ub) anstatt eines Transistorpaars pro Spalte diffundierte Kondensatoren (c) sowie anstatt eines Schmitt-Triggers das NOR-Gatter (ng), über das die Spaltenleitungen des ODER-Bereichs getaktet sind.

EP 0 348 539 A1

FIG.1

## Programmierbares CMOS-Logik-Feld

Die Erfindung betrifft die schaltungstechnisch-halbleitertechnologische Verbesserung von nicht-überlappend zweiphasen-getakteten, in der Technik komplementärer Isolierschicht-Feldeffekttransistoren realisierten programmierbaren Lokig-Feldern, also abgekürzt CMOS-PLAs, wie sie in dem Buch von N.H.E. Weste et al "Principles of CMOS-VLSI Design", Reading, Massachusetts, 1985, Seiten 368-373, insbesondere Kapitel 8.7.4 (Seiten 372/373) beschrieben sind.

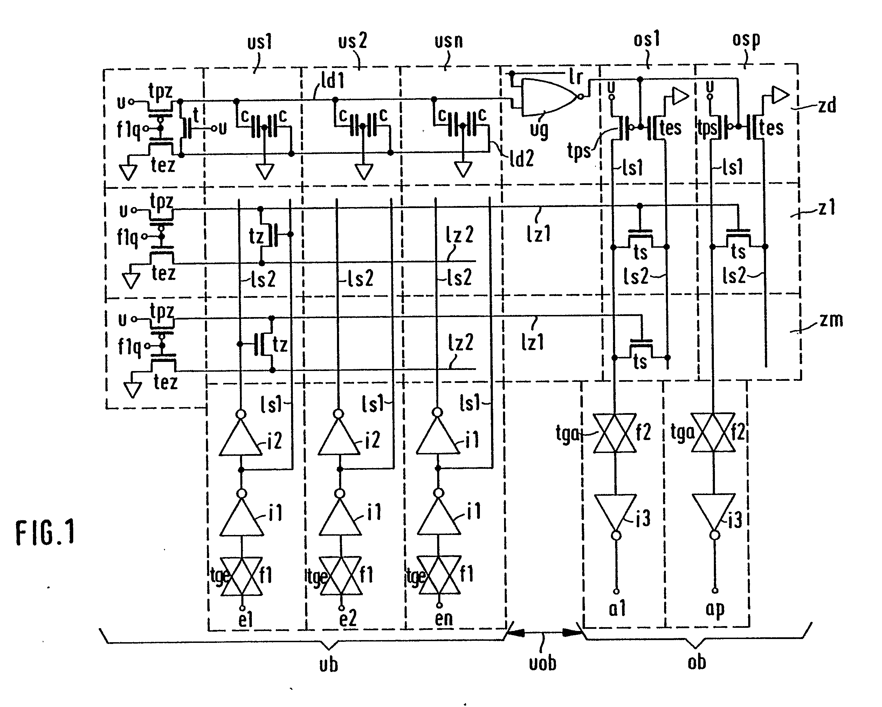

Derartige CMOS-PLAs haben einen UND-Bereich, einen ODER-Bereich und einen diese beiden untereinander verbindenden UND/ODER-Bereich, deren jeweilige Transistoren in m Zeilen sowie n Spalten des UND-Bereichs und in in p Spalten des ODER-Bereichs zwischen jeweils einer ersten und einer zweiten Zeilenleitung bzw. zwischen jeweils einer ersten und einer zweiten Spaltenleitung angeordnet sind. Der internen Taktung dient eine Dummy-Zeile im UND- sowie UND/ODER-Bereich, die ebenfalls zwei Zeilenleitungen hat, sowie ein Schmitt-Trigger, dessen Eingang mit der ersten Zeilenleitung der Dummy-Zeile verbunden ist. Ferner ist in jeder Zeile, in der Dummy-Zeile und in jeder Spalte des ODER-Bereichs ein Precharge-P-Transistor und ein Evaluate-N-Tansistor vorgesehen, deren Gates in den Zeilen und in der Dummy-Zeile vom invertierten ersten Zweiphasen-Takt bzw. in den Spalten vom Ausgangssignal des Schmitt-Triggers angesteuert sind. Dabei liegt der jeweilige gesteuerte Strompfad der Precharge-P-Transistoren zwischen einer Betriebsspannung und der ersten Zeilen- bzw. Spaltenleitung und der des Evaluate-N-Transistors zwischen dem Schaltungsnullpunkt und der zweiten Zeilen- bzw. Spaltenleitung. Schließlich sind im UND-Bereich in der Dummy-Zeile pro Spalte zwei N-Transistoren vorgesehen, deren gesteuerte Strompfade zwischen der ersten und der zweiten Zeilenleitung liegen und von denen das Gate des einen mit der ersten Spaltenleitung und das Gate des anderen mit der zweiten Spaltenleitung verbunden ist. Die Programmierung erfolgt durch Spalten- und Zeilentransistoren, wobei die letzteren im UND-Bereich mit ihrem gesteuerten Strompfad zwischen den beiden Zeilenleitungen einer Zeile angeordnet sind und deren Gate entweder vom nichtinvertierten oder invertierten Eingangssignal angesteuert ist, während die Spaltentransistoren im ODER-Bereich mit ihrem gesteuerten Strompfad zwischen der ersten und der zweiten Spaltenleitung liegen, von denen die erste zum Ausgang führt. Die Anzahl der Zeilen- und Spaltentransistoren und ihre jeweilige Lage im UND- und ODER-Bereich wird durch die beabsichtigte Programmierung bestimmt. Weitere Einzelheiten werden unten in Zusammenhang mit der Erläuterung der Fig. 1 angegeben.

Bei der vorbeschriebenen CMOS-PLA wird zum Abspeichern der Eingangssignale im UND-Bereich eine der Phasen des nichtüberlappenden Zweiphasen-Takts verwendet, während für die Taktung des ODER-Bereichs ein internes Taktsignal mittels der Dummy-Zeile und des erwähnten Schmitt-Triggers erzeugt wird. Dieses muß eine größere Verzögerung aufweisen, als die Auswertzeit in jeder Zeile von UND- und ODER-Bereich beträgt. Diese wird durch die jeweilige Lastkapazität und die Fläche der Zeilen- und Spaltentransistoren bestimmt. Die Lastkapazität setzt sich im wesentlichen aus der Kapazität der Source- bzw. Drainzonen dieser Transistoren zusammen.

Die Anzahl der Zeilentransistoren ist am größten, wenn zwischen jedem Eingang der CMOS-PLA, also entweder dem nichtinvertierten oder invertierten Eingangssignal, und dem entsprechenden Minterm je ein Zeilentransistor sitzt. Die größte Auswertzeit ergibt sich, wenn in einem solchen Minterm aufgrund der Eingangssignale nur ein Zeilentransistor die Leitungskapazität umladen muß. Um diesen Worst-Case bei der Erzeugung des internen Taktsignals zu berücksichtigen, sind bei der vorbeschriebenen CMOS-PLA die Dummy-Zeile und der Schmitt-Trigger vorgesehen. Durch die in der Dummy-Zeile liegenden Transistoren ist die Lastkapazität dieser Zeile doppelt so groß wie die des erläuterten Worst-Cases innerhalb des UND-Bereichs.

Bei der vorbeschriebenen Anordnung ist nicht nur die Hälfte der Transistoren der Dummy-Zeile dauernd stromführend, sondern durch den Schmitt-Trigger und dessen zusätzliche Verzögerung des internen Taktsignals wird auch noch nicht vollständig erreicht, daß Fehlfunktionen ausgeschlossen sind. Hinzu kommt, daß die als integrierte Schaltungen hergestellten CMOS-PLAs herstellungsprozeßabhängige Schwankungen der Verzögerung aufweisen.

Hier will nun die Erfindung Abhilfe schaffen, deren Aufgabe es ist, die vorbeschriebene CMOS-PLA so abzuwandeln und zu verbessern, daß die herstellungsbedingten Verzögerungsschwankungen wesentlich reduziert sind. Auch soll der Schmitt-Trigger durch eine weniger Transistoren aufweisende Teilschaltung ersetzt werden.

Dies gelingt bei der Erfindung im wesentlichen dadurch, daß anstatt der Transistoren der Dummy-Zeile lediglich die in den Ansprüchen im einzelnen definierten Kondensatoren sowie der dort angegebene N-Transistor vorgesehen sind und daß der Schmitt-Trigger durch das NOR-Gatter ersetzt ist.

Die Erfindung wird nun anhand der Figuren der Zeichnungen näher erläutert.

Fig. 1 zeigt in schematischer Schaltbild-Darstellung ein Ausführungsbeispiel der ersten Lösungsvariante der Erfindung mit zwei Zeilenleitungen pro Zeile, und

Fig. 2 zeigt in schematischer Layout- und Schaltbilddarstellung ein Ausführungsbeispiel der zweiten Lösungsvariante der Erfindung.

Bei dem in Fig. 1 in schematischer Schaltbilddarstellung gezeigten Ausführungsbeispiel der ersten Variante der Erfindung sind von den n Spalten des UND-Bereichs ub die Spalten us1, us2, usn zeichnerisch dargestellt, während von den p Spalten des ODER-Bereichs ob die Spalten os1, osp gezeigt sind. Von den m Zeilen sind die Zeilen z1, zm und zusätzlich die Dummy-Zeile zd in Fig. 1 zu sehen. Zwischen dem UND-Bereich ub und dem ODER-Bereich ob liegt der UND/ODER-Bereich uob. Jede Zeile hat die beiden Zeilenleitungen lz1, lz2, wobei die letztere lediglich im UND-Bereich vorhanden ist, die erstere jedoch bis in den ODER-Bereich hineinführt, wobei üblicherweise im UND/ODER-Bereich zwei signalflußmäßig in Serie geschaltete Inverter liegen, über die zur Pegelauffrischung das Signal der Zeilenleitung lz1 geführt ist.

Auch die Spalten haben jeweils die beiden Spaltenleitungen ls1, ls2. Die des UND-Bereichs führen das nichinvertierte und das invertierte Eingangssignal, das vom jeweiligen Eingang e1, e2, en über das jeweilige Eingangs-Transmission-Gate tge, das vom ersten Taktsignal f1 leitend gesteuert ist, und über die beiden Inverter i1, i2 geführt ist. Am Ausgang des Inverters i1 liegt die erste Spaltenleitung ls1 und an dem des zweiten Inverters i2 die zweite Spaltenleitung ls2.

Im ODER-Bereich liegt die erste Spaltenleitung ls1 über das Ausgangs-Transmission-Gate tga, das vom zweiten Taktsignal f2 leitend gesteuert ist, und den dritten Inverter i3 am jeweiligen Ausgang a1, ap.

Die Dummy-Zeile zd hat im UND-Bereich ebenfalls die beiden Zeilenleitungen ld1, ld2, von denen die erste Zeilenleitung ld1 mit dem einen Eingang des NOR-Gatters ng verbunden ist, während dessen anderer Eingang an der Reset-Leitung lr angeschlossen ist.

In jeder Zeile, in der Dummy-Zeile und in jeder Spalte ist der Precharge-P-Transistor tpz, tps vorgesehen, dessen gesteuerter Strompfad die jeweilige erste Zeilenleitung lz1, ld1 und die jeweilige Spaltenleitung ls1 mit der Betriebsspannungquelle u verbindet. Ferner ist in jeder Zeile, der Dummy-Zeile und jeder Spalte des ODER-Bereichs ob der Evaluate-N-Transistor tez, tes vorgesehen, dessen gesteuerter Strompfad die jeweilige zweite Zeilen- bzw. Spaltenleitung lz2, ld2, ls2 mit dem Schaltungsnullpunkt verbindet. In jeder Zeile und in der Dummy-Zeile sind die Gates der beiden Transistoren tpz, tez miteinander verbunden und vom invertierten ersten Taktsignal f1q angesteuert. In jeder Spalte des ODER-Bereichs ob sind die Gates der beiden Transistoren tps, tes ebenfalls miteinander verbunden, jedoch vom Ausgang des ODER-Gatters ng angesteuert.

Im UND-Bereich ub liegt entsprechend der beabsichtigten Programmierung zwischen den beiden Zeilenleitungen lz1, lz2 einer Zeile der gesteuerte Strompfad des Zeilentransistors tz, dessen Gate entweder mit der ersten oder der zweiten Spaltenleitung ls1, ls2 verbunden ist, so daß diese Transistoren entweder vom nichtinvertierten oder vom invertierten Eingangssignal leitend gesteuert werden. In Fig. 1 sind von den möglichen Zeilentransistoren tz diejenigen in den von der Spalte us1 und den Zeilen z1, zm gebildeten UND-Zellen vorhanden gezeigt.

Im ODER-Bereich ob liegt ebenfalls entsprechend der beabsichtigten Programmierung zwischen den beiden Spaltenleitungen ls1, ls2 jeder Spalte der gesteuerte Strompfad des Spaltentransistors ts, dessen Gate mit der jeweiligen ersten Zeilenleitung lz1 verbunden ist. In Fig. 1 sind von den möglichen Spaltentransistoren ts die in den von der Zeile z1 und den Spalten os1, osp gebildeten ODER-Zellen und die in der von der Zeile zm und der Spalte os1 gebildeten ODER-Zelle liegenden Spaltentransistoren eingezeichnet.

In der Dummy-Zeile zd des UND-Bereichs ub zd sind pro Spalte die beiden Kondensatoren c vorgesehen, deren einer zwischen der ersten Zeilenleitung ld1 und dem Schaltungsnullpunkt und deren anderer zwischen der zweiten Zeilenleitung ld2 und dem Schaltungsnullpunkt liegt. Im Ausführungsbeispiel der Fig. 1 sind also 2n Kondensatoren c vorhanden. Dies ist jedoch nicht zwingend, sondern es können auch weniger sein, wobei jedoch mindestens doppelt soviele Kondensatoren vorhanden sein müssen, wie in derjenigen Zeile des UND-Bereichs (ub) vorhanden sind, die von allen diesen Zeilen die meisten Zeilentransistoren tz enthält.

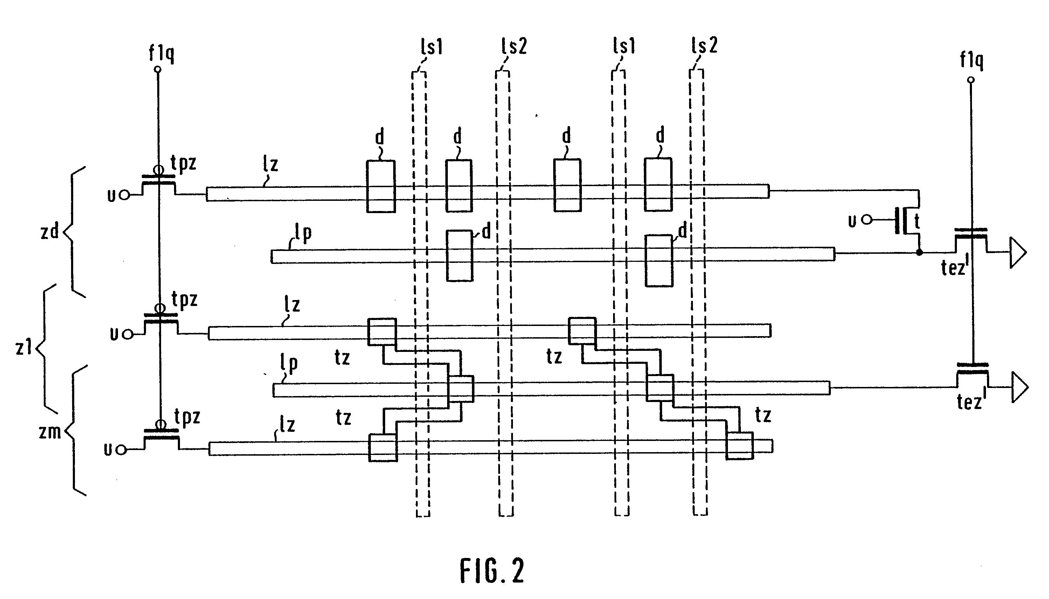

Entsprechend der Erfindung sind die Kondensatoren c von entgegengesetzt zum Substrat dotierten und in ihm angeordneten Zonen (d in Fig. 2) gebildet, die jeweils möglichst dieselbe Fläche und möglichst die dieselbe Randlänge wie die mit der ersten bzw. zweiten Zeilenleitung lz1, lz2 verbundene Zone, also entweder Source- oder Drain, des jeweiligen Zeilentransistors tz hat. Über das Substrat sind die Kondensatoren c somit mit dem Schaltungsnullpunkt verbunden.

In der Dummy-Zeile zd ist nach der Erfindung ferner der zwischen deren Zeilenleitungen ld1, ld2 mit seinem gesteuerten Strompfad liegende, jedoch außerhalb des UND-Bereichs angeordnete N-Transistor t vorgesehen, dessen Gate an der Betriebsspannungsquelle u liegt.

Bei dem in Fig. 2 gezeigten schematischen kombinierten Layout- Schaltbild eines Ausführungsbeispiels der zweiten Lösungsvariante der Erfindung ist zunächst gezeigt, daß in jeweils zwei benachbarten Zeilen einschließlich der Dummy-Zeile nach Fig. 1 die zeiten Zeilenleitungen lz2, ld2 zu der Paarleitung lp zusammengefaßt werden können, wodurch auch in jedem dieser Zeilenpaare anstatt der beiden Evaluate-N-Transistoren der entsprechende Transistor tez' vorzusehen ist. Die jeder Zeile und der Dummy-Zeile noch verbleibende Zeilenleitung ist in Fig. 2 durchgehend mit dem Bezugzeichen lz versehen. Am linken Rand der Fig. 2 ist durch die Klammern angedeutet, welche Zeilen der Fig. 1 durch die Anordnung der Fig. 2 repräsentiert sind.

Der mittlere Teile der Fig. 2 zeigt schematisiert das Layout im UND-Bereich. Die waagrechten Streifen stellen dabei Leitbahnen, z.B. aus Aluminium, dar, während die senkrechten, gepunktet gezeichneten Streifen ebenfalls Leitbahnen, jedoch vorzugsweise aus polykristallinem Silizium, darstellen und die Spaltenleitungen sind. Im die Zeilen z1, zm nach Fig. 1 realisierenden unteren Teil der Fig. 2 sind entsprechende Zeilentransistoren tz mit ihrem Layout schematisch gezeigt, und zwar jeweils ein Transistor zwischen der unteren Zeilenleitung lz und der Paarleitung lp bzw. zwischen dieser und der oberen Zeilenleitung lz. An der Überschneidung zwischen den jeweiligen Quadraten und der Paar- sowie den Zeilenleitungen befindet sich der Drain- bzw. Sourceanschluß des jeweiligen Zeilentransistors, dessen Kanalzone an der Überschneidung des waagrechten Transistorteils mit der jeweiligen Spaltenleitung sich befindet. Die stark umrandeten Gebiete zwischen dem erwähnten Anschlußgebiet und dem Kanalgebiet sind die jeweiligen Drain- bzw. Source-Zonen.

Im linken Teil der Fig. 2 liegt jeweils ein Zeilentransistor tz mit seinem Gate an der Zeilenleitung ls1, während im rechten Teil der Fig. 2 der untere Zeilentransistor tz mit seinem Gate an der Spaltenleitung ls2 angeschlossen ist.

Im oberen Teil der Fig. 2 ist nun dargestellt, daß pro UND-Zelle in der Dummy-Zeile zd maximal drei Zonen d vorzusehen sind, wobei deren maximale Anzahl 3n beträgt, jedoch mindestens dreimal soviele vorhanden sind, wie in derjenigen Zeile des UND-Bereichs liegen, die von allen diesen Zeilen die meisten Zeilentransistoren enthält. Dabei sind zwei Drittel der Zonen d mit der Zeilenleitung lz der Dummy-Zeile zd und ein Drittel mit deren Paarleitung lp kontaktiert. Auch diese Zonen haben möglichst dieselbe Fläche und möglichst dieselbe Randlänge wie die Zonen der zugeordneten Zeilentransistoren tz.

Schließlich ist in Fig. 2 auch der N-Transistor t gezeigt, der in der Dummy-Zeile zd zwichen der Zeilenleitung lz un der Paarleitung lp mit seinem gesteuerten Strompfad angeordnet ist und dessen Gate an der Betriebsspannungsquelle u liegt. Die übrigen Transistoren tpz, tez' entsprechen denen der Fig. 1.

## Ansprüche

1. Nichtüberlappend zweiphasen-getaktetes, in der Technik komplementärer Isolierschicht-Feldeffekttransistoren realisiertes programmierbares Logik-Feld ( = CMOS-PLA)
- mit einem UND-Bereich (ub), einem ODER-Bereich (ob) und einem diese beiden Bereiche untereinander verbindenden UND/ODER-Bereich (uob), deren jeweilige Zeilen- und Spaltentransistoren (tz, ts) in m Zeilen (z1, zm) sowie n Spalten (us1, us2, usn) des UND-Bereichs und in p Spalten (os1, osp) des ODER-Bereichs zwischen jeweils einer ersten und einer zweiten Zeilenleitung (lz1, lz2) bzw. zwischen jeweils einer ersten und einer zweiten Spaltenleitung (ls1, ls2) angeordnet sind,
- mit einer der internen Taktung dienenden Dummy-Zeile (zd) im UND- sowie UND/ODER-Bereich, die ebenfalls zwei Zeilenleitungen (ld1, ld2) hat,
- mit einem NOR-Gatter (ng) in der Dummy-Zeile, dessen einer Eingang mit derer erster Zeilenleitung und dessen anderer Eingang mit einer Reset-Leitung (lr) verbunden ist,
- mit einem Precharge-P-Transistor (tpz, tps) und einem Evaluate-N-Transistor (tez, tes) in jeder Zeile, in der Dummy-Zeile und in jeder Spalte, deren Gates in den Zeilen und in der Dummy-Zeile vom invertierten ersten Zweiphasentakt (f1q) bzw. in den Spalten vom Ausgangssignal des NOR-Gatters (ng) angesteuert sind, wobei der jeweilige gesteuerte Strompfad der Precharge-P-Transistoren (tpz, tps) zwischen einer Betriebsspannung (u) und der ersten Zeilen- bzw. Spaltenleitung (lz1, ld1, ls1) und der des Evaluate-N-Transistors (tez, tes) zwischen dem Schaltungsnullpunkt und der zweiten Zeilenbzw. Spaltenleitung (lz2, ld2, ls2) liegt,
- mit höchstens 2n, jedoch mindestens doppelt sovielen nur Kondensatoren (c) bildenden entgegengesetzt zum Substrat der CMOS-PLA dotierten und in ihm angeordneten Zonen (d), wie in derjenigen Zeile des UND-Bereichs (ub) vorhanden sind, die von allen diesen Zeilen die meisten Zeilentransistoren (tz) enthält, wobei die eine Hälfte der Zonen mit der ersten Zeilenleitung (ld1) der Dummy-Zeile (zd) und die zweite Hälfte mit deren zweiter Zeilenleitung (ld2) kontaktiert ist und jede Zone (d) möglichst dieselbe Fläche und möglichst dieselbe Randlänge wie die mit der ersten bzw. zweiten Zeilenleitung (lz1, lz2) verbundene Zone (= Source bzw. Drain) des jeweiligen Zeilentransistors (tz) hat, und

- mit einem zwischen den Zeilenleitungen (ld1, ld2) der Dummy-Zeile außerhalb des UND-Bereichs liegenden N-Transistor (t), dessen Gate an der Betriebsspannung (u) angeschlossen ist und der dasselbe Layout wie die Zeilentransistoren (tz) hat.

2. Nichtüberlappend zweiphasen-getaktetes, in der Technik komplementärer Isolierschicht-Feldeffekttransistoren realisiertes programmierbares Logik-Feld (= CMOS-PLA)

- mit einem UND-Bereich (ub), einem ODER-Bereich (ob) und einem diese beiden Bereiche untereinander verbindenen UND/ODER-Bereich (uob), deren jeweilige Zeilen- und Spaltentransistoren (tz, ts) in m Zeilen (z1, zm) sowie n Spalten des UND-Bereichs (us1, us2, usn) und in p Spalten (os1, osp) des ODER-Bereichs zwischen jeweils einer ersten und einer zweiten Spaltenleitung (ls1, ls2) angeordnet sind,

- mit einer der internen Taktung dienenden Dummy-Zeile (zd) im UND- sowie UND/ODER-Bereich, die ebenfalls zwei Zeilenleitungen (ld1, ld2) hat,

- mit einem NOR-Gatter (ng) in der Dummy-Zeile, dessen einer Eingang mit deren erster Zeilenleitung und dessen anderer Eingang mit einer Reset-Leitung (lr) verbunden ist,

- mit einem Precharge-P-Transistor (tpz, tps) in jeder Zeile, in der Dummy-Zeile und in jeder Spalte und mit einem Evaluate-N-Transistor (tez', tes) pro Zeilenpaar von Zeilen und Dummy-Zeile sowie in jeder Spalte, wobei deren Gates in den Zeilen und in der Dummy-Zeile vom invertierten ersten Zweiphasentakt (f1q) bzw. in den Spalten vom Ausgangssignal des NOR-Gatters (ng) angesteuert sind und der jeweilige gesteuerte Strompfad der Precharge-P-Transistoren (tpz, tps) zwischen einer Betriebsspannung (u) und einer Zeilen- bzw. der ersten bzw. Spaltenleitung (lz, ls1) und der des Evaluate-N-Transistor (tez', tes) zwischen dem Schaltungsnullpunkt und einer jedem Zeilenpaar gemeinsamen Paarleitung (lp) bzw. der zweiten Spaltenleitung (ls2) liegt,

- mit höchstens 3n, jedoch mindestens dreimal sovielen, nur Kondensatoren (c) bildenden entgegengesetzt zum Substrat der CMOS-PLA dotierten und in ihm angeordneten Zonen (d), wie in derjenigen Zeile des UND-Bereichs (ub) vorhanden sind, die von allen diesen Zeilen die meisten Zeilentransistoren (tz) enthält, wobei zwei Drittel der Zonen (d) mit der Zeilenleitung (lz) der Dummy-Zeile (zd) und ein Drittel mit deren Paarleitung (lp) kontaktiert ist und jede Zone (d) möglichst dieselbe Fläche und möglichst dieselbe Randlänge wie die mit der Paar- bzw. Zeilenleitung verbundene(n) Zone(n) (= Source bzw. Drain) der jeweiligen Zeilentransistoren bzw. des jeweiligen Zeilentransistors hat, und

- mit einem zwischen den Zeilenleitungen (ld1, ld2) der Dummy-Zeile außerhalb des UND-Bereichs liegenden N-Transistor (te'), dessen Gate an der Betriebsspannung (u) angeschlossen ist, und der dasselbe Layout wie die Zeilentransistoren (tz) hat.

FIG.1

FIG. 2

EP 0 348 539 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 178 437 (SIEMENS) * Figur 1; Seite 7, Zeilen 24-30; Seite 8, Zeilen 3-7 * --- | 1 | H 03 K 19/177 H 03 K 5/14 |
| A | PATENT ABSTRACTS OF JAPAN, Band 10, Nr. 283, (E-440)[2339]; & JP-A-61 101 124 (HITACHI MICRO COMPUT ENG LTD) 20-05-1986 * Figur; Zeilen 9-10 * --- | 1 | |
| P,A | N.H.E. WESTE et al.: "Principles of CMOS VLSI design", 1985, Seiten 372-373; Addison-Wesley Publishing Co., Reading, Mass., US ----- | 1 | |

| RECHERCHIERTE SACHGEBIETE (Int. Cl.4) |
|---|
| H 03 K G 11 C |

Der vorliegende Recherchenbericht wurde für alle Patentansprüche erstellt

| Recherchenort | Abschlußdatum der Recherche | Prüfer |
|---|---|---|
| DEN HAAG | 02-03-1989 | FEUER F.S. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
................................................................
& : Mitglied der gleichen Patentfamilie, übereinstimmendes Dokument